# EUROPÄISCHE PATENTSCHRIFT

(11) **EP 3 062 398 B1**
(45) Veröffentlichungstag und Bekanntmachung des Hinweises auf die Patenterteilung: **10.04.2019**
(21) Anmeldenummer: 16153989.5
(22) Anmeldetag: 03.02.2016
(51) Int. Cl.: H01R 12/72, H05B 6/12, H05K 5/00

(54) **KOCHFELDVORRICHTUNG**
COOKING HOB DEVICE
DISPOSITIF DE PLAQUE DE CUISSON

(30) Priorität: 24.02.2015 ES 201530228
(43) Veröffentlichungstag der Anmeldung: 31.08.2016
(73) Patentinhaber: BSH Hausgeräte GmbH, 81739 München (DE)
(72) Erfinder: Arnal Valero, Adolfo, 50009 Zaragoza (ES); Ceamanos Gaya, Jesús, 50016 Zaragoza (ES); Lapetra Campos, Isaac, 50003 Zaragoza (ES); Sanchez Garcia, Eva Maria, 50013 Zaragoza (ES)

(56) Entgegenhaltungen:
- EP-A2- 2 175 461
- DE-A1-102006 028 472
- US-A- 5 494 451
- US-A1- 2002 173 202

## Beschreibung

Die Erfindung geht aus von einer Kochfeldvorrichtung nach dem Oberbegriff des Patentanspruchs 1 und von einem Verfahren zur Montage einer Kochfeldvorrichtung nach dem Oberbegriff des Patentanspruchs 10.

Aus der europäischen Patentanmeldung EP 2 175 461 A2 ist bereits eine Kochfeldvorrichtung mit einer Leiterplatte und einem Randkartenstecker bekannt, der eine Leiterbahn der Leiterplatte kontaktiert. Der Randkartenstecker wird hierbei lediglich auf die Leiterplatte aufgesteckt, wobei von einer Sicherung einer Position des Randkartensteckers relativ zu der Leiterplatte abgesehen wird. Eine elektrische Vorrichtung mit einem Randkartenstecker, der dazu vorgesehen ist, eine Leiterplatte zu kontaktieren, ist aus der Druckschrift DE 10 2006 028472 A1 bekannt.

Die Aufgabe der Erfindung besteht insbesondere darin, eine gattungsgemäße Vorrichtung mit verbesserten Eigenschaften hinsichtlich einer hohen Zuverlässigkeit bereitzustellen.

Die Aufgabe wird erfindungsgemäß durch die kennzeichnenden Merkmale der Patentansprüche 1 und 10 gelöst, während vorteilhafte Ausgestaltungen und Weiterbildungen der Erfindung den Unteransprüchen entnommen werden können.

Die Erfindung geht aus von einer Kochfeldvorrichtung, insbesondere einer Induktionskochfeldvorrichtung, mit zumindest einem Randkartenstecker, der dazu vorgesehen ist, eine Leiterplatte, insbesondere zumindest eine Leiterbahn der Leiterplatte, zu kontaktieren, insbesondere elektrisch leitend zu kontaktieren.

Es wird vorgeschlagen, dass die Kochfeldvorrichtung zumindest ein Positionierungselement umfasst, das von dem Randkartenstecker verschieden ausgebildet und dazu vorgesehen ist, den Randkartenstecker in einer Position relativ zu der Leiterplatte zu fixieren. Unter einer "Kochfeldvorrichtung" soll insbesondere zumindest ein Teil, insbesondere eine Unterbaugruppe, eines Kochfelds, insbesondere eines Induktionskochfelds, verstanden werden. Insbesondere kann die Kochfeldvorrichtung auch das gesamte Kochfeld, insbesondere das gesamte Induktionskochfeld, umfassen. Unter einem "Randkartenstecker" soll insbesondere ein Element verstanden werden, das auf einen Randbereich einer Leiterplatte aufsteckbar und/oder aufschiebbar ist und das insbesondere dazu vorgesehen ist, eine elektrisch leitende Verbindung zu zumindest einer insbesondere zumindest teilweise in dem Randbereich angeordneten Leiterbahn der Leiterplatte herzustellen. Unter einem "Randbereich" einer Leiterplatte soll insbesondere ein Bereich verstanden werden, der in einer parallel zu einer Haupterstreckungsebene der Leiterplatte ausgerichteten Richtung einen minimalen Abstand von maximal 20 %, insbesondere von maximal 15 %, vorteilhaft von maximal 10 % und vorzugsweise von maximal 5 % einer Längserstreckung der Leiterplatte zu einer seitlichen Begrenzung der Leiterplatte aufweist, wobei der minimale Abstand senkrecht zu der seitlichen Begrenzung der Leiterplatte ausgerichtet ist. Unter einer "Haupterstreckungsebene" eines Objekts soll insbesondere eine Ebene verstanden werden, welche parallel zu einer größten Seitenfläche eines kleinsten gedachten Quaders ist, welcher das Objekt gerade noch vollständig umschließt, und insbesondere durch den Mittelpunkt des Quaders verläuft. Vorteilhaft umfasst die Kochfeldvorrichtung die Leiterplatte. Unter einer "Längserstreckung" eines Objekts soll insbesondere eine Länge einer längsten Seite eines kleinsten gedachten Quaders verstanden werden, welcher das Objekt gerade noch vollständig umschließt. Unter einer "Leiterplatte" soll insbesondere ein Bauteil verstanden werden, das in wenigstens einem montierten Zustand zu einer insbesondere elektrischen Verbindung von elektrischen Komponenten und/oder zu einer insbesondere mechanischen Befestigung von elektrischen Komponenten vorgesehen ist und vorteilhaft eine Gewichtskraft der elektrischen Komponenten wenigstens zu einem Großteil trägt und/oder an ein weiteres Bauteil, wie beispielsweise eine Gehäuseeinheit, weiterleitet. Die elektrischen Komponenten können hierbei beispielsweise als elektrische Bauteile, beispielsweise Wechselrichterbauteile, ausgebildet sein. Insbesondere weist die Leiterplatte zumindest eine Leiterbahn auf, welche insbesondere zu einer Kontaktierung durch den Randkartenstecker vorgesehen ist. Die Leiterplatte umfasst insbesondere ein elektrisch isolierendes Substrat, wobei insbesondere verschiedene Materialien denkbar sind, wie beispielsweise FR1, FR2, FR3, FR4, FR5, CEM-1, CEM-3 und/oder Teflon. Unter einem "Positionierungselement" soll insbesondere ein Element verstanden werden, das dazu vorgesehen ist, den Randkartenstecker und/oder die Leiterplatte zu einer Fixierung einer Position des Randkartensteckers relativ zu der Leiterplatte wenigstens teilweise zu berühren. Das Positionierungselement und der Randkartenstecker sind insbesondere relativ zueinander beweglich angeordnet und insbesondere als voneinander unabhängige Baueinheiten ausgebildet. Das Positionierungselement ist insbesondere dazu vorgesehen, in wenigstens einem montierten Zustand eine Bewegung des Randkartensteckers relativ zu der Leiterplatte auf eine Strecke von maximal 0,5 cm, insbesondere von maximal 0,3 cm, vorteilhaft von maximal 0,2 cm und vorzugsweise von maximal 0,1 cm zu begrenzen. Unter "vorgesehen" soll insbesondere speziell ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungs- und/oder Betriebszustand erfüllt und/oder ausführt.

Durch die erfindungsgemäße Ausgestaltung kann insbesondere eine hohe Zuverlässigkeit erreicht werden. Der Randkartenstecker kann insbesondere in einer Position relativ zu der Leiterplatte gesichert werden. Insbesondere kann ein Verlust und/oder eine Entkopplung des Randkartensteckers, beispielsweise bei einem Transport, und insbesondere eine damit verbundene Beschädigung der Leiterplatte und/oder des Randkartensteckers und/oder des gesamten Kochfelds vermieden werden. Vorteilhaft kann der Sicherheitsstandard IEC 60335-1 eingehalten werden.

Ferner wird vorgeschlagen, dass das Positionierungselement dazu vorgesehen ist, den Randkartenstecker von einer der Leiterplatte abgewandten Seite her in der Position relativ zu der Leiterplatte zu fixieren. Insbesondere ist das Positionierungselement dazu vorgesehen, die der Leiterplatte abgewandte Seite des Randkartensteckers wenigstens teilweise zu berühren. Dadurch kann besonders vorteilhaft ein unbeabsichtigtes Entfernen des Randkartensteckers aus der Position relativ zu der Leiterplatte und damit ein Lösen einer Verbindung zwischen dem Randkartenstecker und der Leiterplatte vermieden werden.

In einer bevorzugten Ausgestaltung der Erfindung wird vorgeschlagen, dass die Kochfeldvorrichtung eine Gehäuseeinheit umfasst, mit welcher das Positionierungselement verbunden ist. Unter einer "Gehäuseeinheit" soll insbesondere eine Einheit verstanden werden, die in wenigstens einen montierten Zustand wenigstens teilweise eine Begrenzung zumindest eines Hohlraums ausbildet, welcher dazu vorgesehen ist, in einem montierten Zustand zumindest eine Einheit und/oder zumindest ein Element insbesondere der Kochfeldvorrichtung aufzunehmen, wie beispielsweise eine Bedieneinheit und/oder eine Steuereinheit und/oder ein Heizelement und/oder eine Versorgungselektronik und/oder eine Energiequelle. Unter der Wendung, dass die Gehäuseeinheit "wenigstens teilweise" eine Begrenzung zumindest eines Hohlraums ausbildet, soll insbesondere verstanden werden, dass die Gehäuseeinheit einen Anteil von mindestens 10 %, insbesondere von mindestens 20 %, vorteilhaft von mindestens 30 %, besonders vorteilhaft von mindestens 40 % und vorzugsweise von mindestens 50 % eines Flächenanteils der Begrenzung des Hohlraums ausbildet. Insbesondere weist die Gehäuseeinheit zumindest ein Halteelement auf, das dazu vorgesehen ist, die Leiterplatte in einer Position relativ zu einer Haupterstreckungsebene der Gehäuseeinheit zu halten und insbesondere eine Auflagefläche bereitzustellen, auf welcher die Leiterplatte insbesondere in einem montierten Zustand aufliegt. Alternativ oder zusätzlich könnte die Gehäuseeinheit zumindest ein Fixierungselement aufweisen, das dazu vorgesehen sein könnte, die Position der Leiterplatte relativ zu der Haupterstreckungsebene der Gehäuseeinheit zu fixieren und insbesondere die Leiterplatte an der Gehäuseeinheit zu befestigen, beispielsweise mittels eines Befestigungsmittels wie einer Schraube und/oder einem Rastelement. Die Gehäuseeinheit ist vorzugsweise aus wenigstens einem elektrisch isolierenden Material ausgebildet. Beispielsweise könnte die Gehäuseeinheit wenigstens teilweise aus Keramik und/oder vorteilhaft aus Kunststoff ausgebildet sein, insbesondere aus einem thermoplastischen Material, wie beispielsweise Polypropylen und/oder Polyamid und/oder Polycarbonat. Die Kochfeldvorrichtung kann insbesondere eine weitere Gehäuseeinheit umfassen, welche insbesondere ein Außengehäuse und insbesondere einen weiteren Hohlraum ausbildet, innerhalb welchem die Gehäuseeinheit insbesondere in einem montierten Zustand angeordnet sein kann. Insbesondere kann die Gehäuseeinheit als ein Innengehäuse ausgebildet sein. Dadurch kann insbesondere eine stabile und/oder geschützte Anordnung des Positionierungselements ermöglicht werden.

Das Positionierungselement könnte beispielsweise als eine zusätzliche Baueinheit ausgebildet sein, die insbesondere frei positionierbar mit der Gehäuseeinheit verbindbar sein könnte. Vorzugsweise ist das Positionierungselement einstückig mit der Gehäuseeinheit verbunden. Die Gehäuseeinheit ist vorzugsweise einstückig ausgebildet. Besonders vorteilhaft ist die Gehäuseeinheit als ein Spritzgussteil ausgebildet. Unter "einstückig" soll insbesondere zumindest stoffschlüssig verbunden verstanden werden, beispielsweise durch einen Schweißprozess, einen Klebeprozess, einen Anspritzprozess und/oder einen anderen, dem Fachmann als sinnvoll erscheinenden Prozess, und/oder vorteilhaft in einem Stück geformt verstanden werden, wie beispielsweise durch eine Herstellung aus einem Guss und/oder durch eine Herstellung in einem Ein- oder Mehrkomponentenspritzverfahren und vorteilhaft aus einem einzelnen Rohling. Dadurch kann insbesondere eine preisgünstige Ausgestaltung ermöglicht und auf weitere Bauteile zu einer Sicherung einer Position des Randkartensteckers relativ zu der Leiterplatte verzichtet werden, da die Gehäuseeinheit insbesondere zumindest zwei Funktionen übernehmen kann. Insbesondere kann auf eine Vormontage verzichtet werden. Vorteilhaft kann auf eine Fertigung weiterer Bauteile und damit verbunden insbesondere auf ein zusätzliches Spritzgussverfahren verzichtet werden.

Ferner wird vorgeschlagen, dass das Positionierungselement zumindest teilweise relativ zu zumindest einem Teilbereich der Gehäuseeinheit auslenkbar ist. Das Positionierungselement ist insbesondere von wenigstens einer Fixierstellung, in welcher das Positionierungselement den Randkartenstecker in der Position relativ zu der Leiterplatte fixiert, in wenigstens eine Auslenkstellung, in welcher der Randkartenstecker aus der Position relativ zu der Leiterplatte entfernbar und/oder von der Leiterplatte trennbar ist, und zurück überführbar. Dadurch kann beispielsweise im Fall einer Reparatur und/oder einer Nachrüstung insbesondere eine einfache Herstellung und/oder Lösung einer Verbindung zwischen dem Randkartenstecker und der Leiterplatte ermöglicht werden.

In einer besonders bevorzugten Ausgestaltung der Erfindung wird vorgeschlagen, dass die Gehäuseeinheit zumindest eine Ausnehmung aufweist, die dazu vorgesehen ist, das Positionierungselement in wenigstens einer Auslenkstellung wenigstens zu einem Großteil aufzunehmen. Unter der Wendung, dass die Ausnehmung dazu vorgesehen ist, das Positionierungselement in wenigstens einer Auslenkstellung "wenigstens zu einem Großteil" aufzunehmen, soll insbesondere verstanden werden, dass die Ausnehmung in der Auslenkstellung des Positionierungselements einen Massenanteil und/oder Volumenanteil des Positionierungselements von mindestens 70 %, insbesondere von mindestens 80 %, vorteilhaft von mindestens 90 % und vorzugsweise von mindestens 95 % aufnimmt. Hierdurch kann eine vorteilhaft einfache und platzsparende Konstruktion erreicht werden.

Weiterhin wird vorgeschlagen, dass das Positionierungselement zumindest einen Betätigungsabschnitt zu einer Auslenkung des Positionierungselements aus einer Fixierstellung in die Auslenkstellung aufweist. Beispielsweise könnte der Betätigungsabschnitt zu einer insbesondere direkten Betätigung durch eine Person, wie insbesondere einen Mechaniker und/oder Monteur, vorgesehen sein. Der Betätigungsabschnitt könnte alternativ oder zusätzlich zu einer Betätigung mittels des Randkartensteckers vorgesehen sein. Hierbei könnte der Randkartenstecker insbesondere bei einer Montage in einer Vertikalrichtung bezüglich der Haupterstreckungsebene der Leiterplatte auf den Betätigungsabschnitt aufgebracht werden, um das Positionierungselement aus der Fixierstellung in die Auslenkstellung auszulenken. Der Randkartenstecker könnte anschließend in einer parallel zu der Haupterstreckungsebene der Leiterplatte ausgerichteten Befestigungsrichtung in die Position relativ zu der Leiterplatte bewegt werden. Dadurch kann insbesondere eine einfache Montage und/oder Demontage des Randkartensteckers erzielt werden.

Ferner wird vorgeschlagen, dass das Positionierungselement als eine aus einer Wand, insbesondere aus einer Bodenwand, der Gehäuseeinheit freigestellte Zunge ausgebildet ist. Das Positionierungselement weist insbesondere zumindest einen Abschnitt, insbesondere zumindest einen Betätigungsabschnitt, auf, welcher insbesondere wenigstens im Wesentlichen parallel zu der Gehäuseeinheit, insbesondere zu einer Haupterstreckungsebene der Gehäuseeinheit, ausgerichtet und insbesondere mit der Gehäuseeinheit verbunden ist, wobei eine Verbindung zwischen der Gehäuseeinheit und dem Abschnitt insbesondere mittels zumindest eines Verbindungsabschnitts des Positionierungselements erfolgt. Zumindest eine äußere Begrenzung des Positionierungselements, welche an einem Kontaktpunkt der Zunge mit der Wand der Gehäuseeinheit abgewandt angeordnet ist, weist insbesondere einen Abstand von mindestens 0,1 mm, insbesondere von mindestens 0,2 mm, vorteilhaft von mindestens 0,3 mm und vorzugsweise von mindestens 0,5 mm zu einem nächstliegenden Punkt der Wand auf, wobei der Abstand insbesondere senkrecht zu der äußeren Begrenzung der Zunge ausgerichtet ist. Das Positionierungselement könnte beispielsweise wenigstens im Wesentlichen parallel zu einer Haupterstreckungsebene der Wand der Gehäuseeinheit ausgerichtet sein und insbesondere gemeinsam mit der Wand eine Ebene definieren. Vorteilhaft überragt das Positionierungselement, insbesondere der Abschnitt des Positionierungselements und vorteilhaft der Betätigungsabschnitt des Positionierungselements, in einem montierten Zustand, in welchem das Positionierungselement insbesondere den Randkartenstecker in der Position relativ zu der Leiterplatte fixiert, die Haupterstreckungsebene der Wand, insbesondere die Haupterstreckungsebene der Gehäuseeinheit, um eine senkrecht zu der Wand, insbesondere zu der Haupterstreckungsebene, ausgerichtete Strecke von mindestens 0,2 mm, insbesondere von mindestens 0,5 mm, vorteilhaft von mindestens 1 mm und vorzugsweise von mindestens 1,5 mm. Dadurch kann insbesondere eine flexible und vorteilhaft einfache Ausgestaltung erzielt werden.

Die Erfindung geht weiterhin aus von einem Verfahren zur Montage einer Kochfeldvorrichtung, insbesondere einer Induktionskochfeldvorrichtung, mit einer Leiterplatte und zumindest einem Randkartenstecker, der mit einer Leiterplatte kontaktiert wird.

Es wird vorgeschlagen, dass der Randkartenstecker in einer Position relativ zu der Leiterplatte mittels zumindest eines Positionierungselements, das von dem Randkartenstecker verschieden ausgebildet ist, fixiert wird, wodurch eine hohe Zuverlässigkeit erreicht werden kann.

Weiterhin wird vorgeschlagen, dass das Positionierungselement bei insbesondere einer Herstellung einer Kontaktierung des Randkartensteckers mit der Leiterplatte durch den Randkartenstecker aus einer Fixierstellung in eine Auslenkstellung überführt, insbesondere bewegt und/oder ausgelenkt, wird. Dadurch kann insbesondere eine einfache Montage und/oder Demontage ermöglicht werden.

Die Kochfeldvorrichtung soll hierbei nicht auf die oben beschriebene Anwendung und Ausführungsform beschränkt sein. Insbesondere kann die Kochfeldvorrichtung zu einer Erfüllung einer hierin beschriebenen Funktionsweise eine von einer hierin genannten Anzahl von einzelnen Elementen, Bauteilen und Einheiten abweichende Anzahl aufweisen.

Weitere Vorteile ergeben sich aus der folgenden Zeichnungsbeschreibung. In der Zeichnung sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein Kochfeld mit einer Kochfeldvorrichtung in einer schematischen Draufsicht,
- Fig. 2: eine Gehäuseeinheit und zwei Positionierungselemente der Kochfeldvorrichtung in einer schematischen perspektivischen Darstellung,
- Fig. 3: die Gehäuseeinheit, die Positionierungselemente und eine Leiterplatte der Kochfeldvorrichtung in einer schematischen perspektivischen Darstellung,
- Fig. 4: die Gehäuseeinheit, die Positionierungselemente, die Leiterplatte und zwei Randkartenstecker der Kochfeldvorrichtung in einer schematischen perspektivischen Darstellung,
- Fig. 5: einen Schnitt entlang der Linie V-V der Figur 4 und
- Fig. 6: eine alternative Gehäuseeinheit und zwei alternative Positionierungselemente einer alternativen Kochfeldvorrichtung in einer schematischen Darstellung.

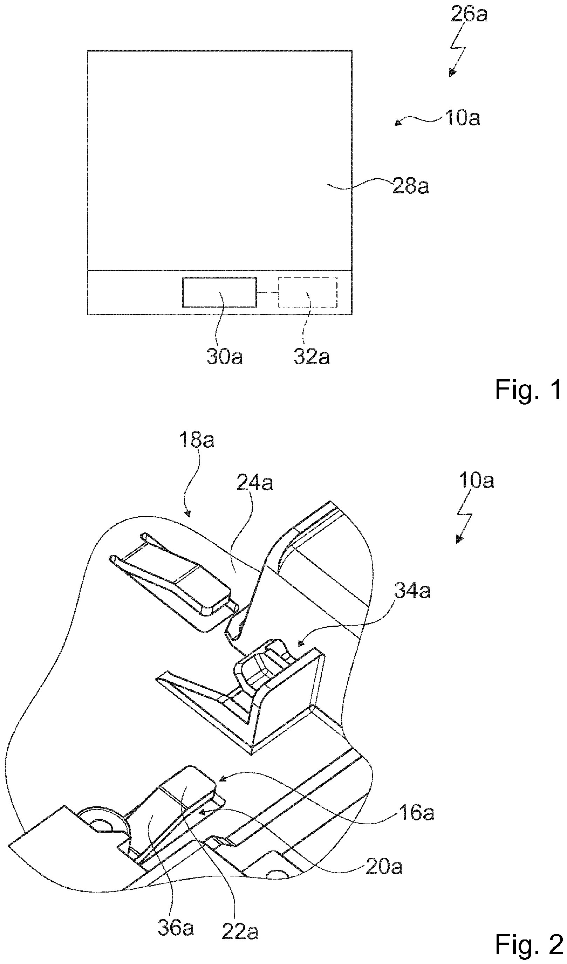

Fig. 1 zeigt ein Kochfeld 26a, das als ein Induktionskochfeld ausgebildet ist, mit einer Kochfeldvorrichtung 10a, die als eine Induktionskochfeldvorrichtung ausgebildet ist. Die Kochfeldvorrichtung 10a umfasst eine Kochfeldplatte 28a. In einem montierten Zustand bildet die Kochfeldplatte 28a einen Teil eines Außengehäuses aus, und zwar insbesondere eines Außengehäuses des Kochfelds 26a. Die Kochfeldplatte 28a ist zu einem Aufstellen von Gargeschirr vorgesehen. Zudem umfasst die Kochfeldvorrichtung 10a mehrere Heizelemente (nicht dargestellt), die jeweils dazu vorgesehen sind, auf der Kochfeldplatte 28a oberhalb der Heizelemente aufgestelltes Gargeschirr zu erhitzen.

Die Kochfeldvorrichtung 10a umfasst eine Bedieneinheit 30a zu einer Eingabe und/oder Auswahl von Betriebsparametern, beispielsweise einer Heizleistung und/oder einer Heizleistungsdichte und/oder einer Heizzone. Die Bedieneinheit 30a ist zu einer Ausgabe eines Werts eines Betriebsparameters an einen Bediener vorgesehen. Die Kochfeldvorrichtung 10a umfasst eine Steuereinheit 32a, die dazu vorgesehen ist, in Abhängigkeit von mittels der Bedieneinheit 30a eingegebener Betriebsparameter Aktionen auszuführen und/oder Einstellungen zu verändern. Die Steuereinheit 32a regelt in einem Heizbetriebszustand eine Energiezufuhr zu den Heizelementen.

In dem montierten Zustand sind die Steuereinheit 32a sowie die Bedieneinheit 30a in dem Außengehäuse angeordnet. Die Kochfeldvorrichtung 10a umfasst eine Gehäuseeinheit 18a. Die Kochfeldvorrichtung 10a umfasst eine weitere Gehäuseeinheit (nicht dargestellt). Die weitere Gehäuseeinheit bildet einen Teil des Außengehäuses aus. In dem montierten Zustand sind die weitere Gehäuseeinheit und die Kochfeldplatte 28a aneinander befestigt (nicht dargestellt). Die Kochfeldplatte 28a bildet in dem montierten Zustand und in einer Einbaulage einen einem Bediener zugewandten Teil des Außengehäuses aus. Die weitere Gehäuseeinheit bildet in dem montierten Zustand und in der Einbaulage einen einem Bediener abgewandten Teil des Außengehäuses aus. In dem montierten Zustand bilden die weitere Gehäuseeinheit und die Kochfeldplatte 28a einen Hohlraum aus, in welchem die Gehäuseeinheit 18a angeordnet ist. Die Gehäuseeinheit 18a ist als ein Innengehäuse ausgebildet. In dem montierten Zustand liegt die Gehäuseeinheit 18a teilweise auf der weiteren Gehäuseeinheit auf. Die Gehäuseeinheit 18a definiert einen Hohlraum, in welchem Komponenten der Kochfeldvorrichtung 10a angeordnet sind und welcher insbesondere im Wesentlichen dem durch die weitere Gehäuseeinheit und die Kochfeldplatte 28a gebildeten Hohlraum entspricht.

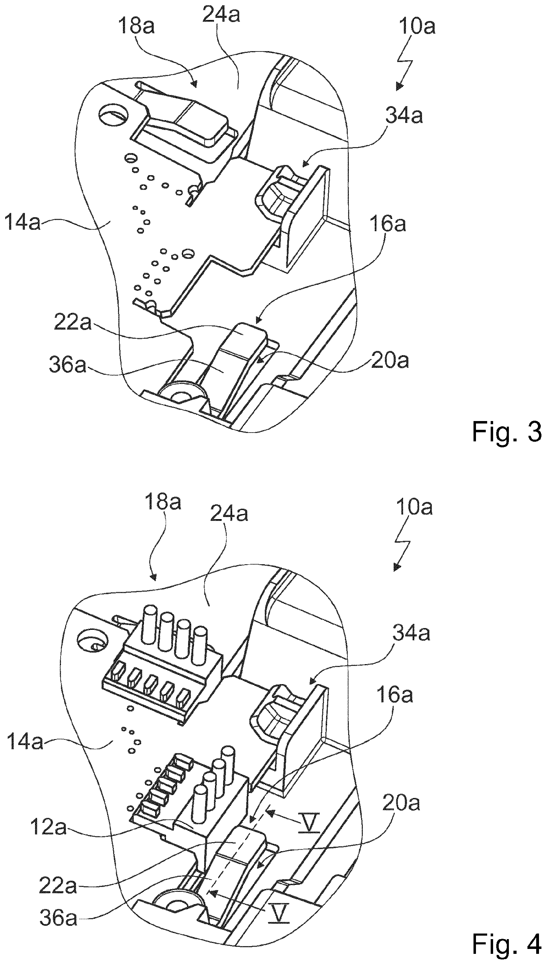

Die Kochfeldvorrichtung 10a umfasst mehrere Leiterplatten 14a (vgl. Fig. 3). Im Folgenden wird lediglich eine der Leiterplatten 14a beschrieben. Zudem ist lediglich einer der Leiterplatten 14a in den Figuren dargestellt. Die Leiterplatte 14a ist in dem montierten Zustand innerhalb der Gehäuseeinheit 18a angeordnet. Die Gehäuseeinheit 18a weist ein Halteelement 34a auf, das in dem montierten Zustand die Leiterplatte 14a in einer Position relativ zu einer Haupterstreckungsebene der Gehäuseeinheit 18a hält (vgl. Fig. 2 und 3). Das Halteelement 34a hält die Leiterplatte 14a in dem montierten Zustand mittels einer formschlüssigen und/oder kraftschlüssigen Verbindung. In dem montierten Zustand klemmt das Halteelement 34a einen Teilbereich der Leiterplatte 14a zwischen zwei Teilbereichen des Halteelements 34a ein.

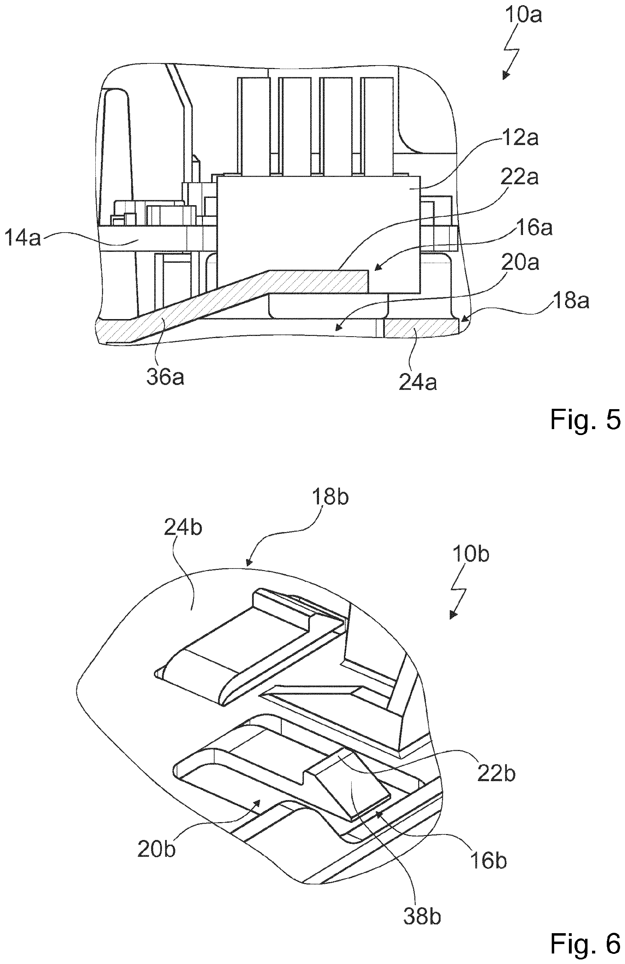

Die Kochfeldvorrichtung 10a umfasst mehrere Randkartenstecker 12a (vgl. Fig. 4 und 5). Im Folgenden wird lediglich einer der Randkartenstecker 12a beschrieben. In den Figuren ist von mehrfach vorhandenen Baueinheiten jeweils lediglich eine mit einem Bezugszeichen versehen. Der Randkartenstecker 12a kontaktiert die Leiterplatte 14a in dem montierten Zustand. Hierbei kontaktiert der Randkartenstecker 12a eine Leiterbahn (nicht dargestellt) der Leiterplatte 14a. Der Randkartenstecker 12a umgreift einen Teilbereich der Leiterplatte 14a. Beispielsweise könnte der Randkartenstecker als ein Rast 2.5 Steckverbinder und/oder als ein Rast 5 Steckverbinder und/oder als ein JST Steckverbinder ausgebildet sein. Der Randkartenstecker könnte beispielsweise Teil einer elektrischen und/oder elektronischen Verbindung sein, die zu einer Signalübertragung zwischen verschiedenen Leiterplatten vorgesehen sein könnte.

Die Kochfeldvorrichtung 10a umfasst mehrere Positionierungselemente 16a (vgl. Fig. 2 bis 5). Im Folgenden wird lediglich eines der Positionierungselemente 16a beschrieben. Das Positionierungselement 16a ist von dem Randkartenstecker 12a verschieden ausgebildet. Das Positionierungselement 16a und der Randkartenstecker 12a sind als separate Baueinheiten ausgebildet. In dem montierten Zustand fixiert das Positionierungselement 16a den Randkartenstecker 12a in einer Position relativ zu der Leiterplatte 14a. Das Positionierungselement 16a fixiert den Randkartenstecker 12a von einer der Leiterplatte 14a abgewandten Seite her in der Position relativ zu der Leiterplatte 14a.

Das Positionierungselement 16a ist in dem montierten Zustand mit der Gehäuseeinheit 18a verbunden. Hierbei ist das Positionierungselement 16a einstückig mit der Gehäuseeinheit 18a verbunden. Das Positionierungselement 16a verhindert in dem montierten Zustand eine Bewegung des Randkartensteckers 12a relativ zu der Leiterplatte 14a in einer parallel zu der Haupterstreckungsebene der Gehäuseeinheit 18a ausgerichteten Richtung.

Das Positionierungselement 16a ist als eine aus einer Wand 24a der Gehäuseeinheit 18a freigestellte Zunge ausgebildet. Beispielsweise könnte das Positionierungselement aus einer Seitenwand der Gehäuseeinheit freigestellt ausgebildet sein, wobei der Randkartenstecker in einem Nahbereich der Seitenwand der Gehäuseeinheit angeordnet sein und das Positionierungselement den Randkartenstecker in der Position relativ zu der Leiterplatte fixieren könnte. Im vorliegenden Ausführungsbeispiel ist das Positionierungselement 16a als aus einer Bodenwand der Gehäuseeinheit 18a freigestellt ausgebildet.

Das Positionierungselement 16a ist relativ zu einem Teilbereich der Gehäuseeinheit 18a auslenkbar angeordnet. Das Positionierungselement 16a ist relativ zu der Wand 24a, insbesondere zu der Bodenwand, der Gehäuseeinheit 18a auslenkbar angeordnet. Die Wand 24a, insbesondere die Bodenwand, der Gehäuseeinheit 18a ist im Wesentlichen parallel zu der Haupterstreckungsebene der Gehäuseeinheit 18a ausgerichtet. Das Positionierungselement 16a ist relativ zu der Haupterstreckungsebene der Gehäuseeinheit 18a auslenkbar angeordnet.

Die Gehäuseeinheit 18a weist mehrere Ausnehmungen 20a auf (vgl. Fig. 2 bis 5). Eine Anzahl an Ausnehmungen 20a und eine Anzahl an Positionierungselementen 16a ist im Wesentlichen identisch. Im Folgenden wird lediglich eine der Ausnehmungen 20a beschrieben. Die Ausnehmung 20a ist in der Wand 24a, insbesondere in der Bodenwand, der Gehäuseeinheit 18a angeordnet. Die Ausnehmung 20a nimmt das Positionierungselement 16a in einer Auslenkstellung des Positionierungselements 16a zu einem Großteil auf. Die Ausnehmung 20a ist unwesentlich größer ausgebildet als das Positionierungselement 16a. Das Positionierungselement 16a ist an einer seitlichen Begrenzungskante der Ausnehmung 20a einstückig mit der Gehäuseeinheit 18a verbunden. In der Auslenkstellung ragt das Positionierungselement 16a teilweise durch die Gehäuseeinheit 18a, insbesondere durch die Wand 24a der Gehäuseeinheit 18a, hindurch. Das Positionierungselement 16a ist in der Auslenkstellung teilweise auf einer der Leiterplatte 14a abgewandten Seite der Gehäuseeinheit 18a angeordnet. In der Auslenkstellung ist der Randkartenstecker 12a aus der Position relativ zu der Leiterplatte 14a entfernbar und/oder von der Leiterplatte 14a trennbar.

Das Positionierungselement 16a weist einen Betätigungsabschnitt 22a zu einer Auslenkung des Positionierungselements 16a aus einer Fixierstellung in die Auslenkstellung auf (vgl. Fig. 2 bis 5). Der Betätigungsabschnitt 22a ist im Wesentlichen parallel zu der Haupterstreckungsebene der Gehäuseeinheit 18a ausgerichtet. In der Fixierstellung fixiert das Positionierungselement 16a den Randkartenstecker 12a in der Position relativ zu der Leiterplatte 14a. Das Positionierungselement 16a ist in der Fixierstellung zu einem Großteil auf einer der Leiterplatte 14a zugewandten Seite der Gehäuseeinheit 18a angeordnet.

Das Positionierungselement 16a weist einen Verbindungsabschnitt 36a auf. Der Verbindungsabschnitt 36a verbindet den Betätigungsabschnitt 22a mit der Wand 24a, insbesondere mit der Bodenwand, der Gehäuseeinheit 18a. Der Verbindungsabschnitt 36a ist schräg relativ zu der Wand 24a, insbesondere zu der Bodenwand, vorteilhaft zu der Haupterstreckungsebene, der Gehäuseeinheit 18a ausgerichtet. Beispielsweise könnte der Verbindungsabschnitt mit der Wand, insbesondere mit der Bodenwand, vorteilhaft mit der Haupterstreckungsebene, der Gehäuseeinheit einen Winkel in einem Bereich von 5° bis 50°, insbesondere von 10° bis 30°, einschließen.

In einem Verfahren zur Montage der Kochfeldvorrichtung 10a wird der Randkartenstecker 12a mit der Leiterplatte 14a kontaktiert. Der Randkartenstecker 12a wird in einer im Wesentlichen senkrecht zu der Haupterstreckungsebene der Gehäuseeinheit 18a ausgerichteten Vertikalrichtung dem Positionierungselement 16a angenähert. Mittels des Randkartenstreckers 12a wird der Betätigungsabschnitt 22a des Positionierungselements 16a bei fortschreitender Bewegung des Randkartensteckers 12a in der Vertikalrichtung betätigt. Das Positionierungselement 16a wird relativ zu der Wand 24a, insbesondere zu der Bodenwand, vorteilhaft zu der Haupterstreckungsebene, der Gehäuseeinheit 18a mittels des Randkartensteckers 12a ausgelenkt. Hierbei wird das Positionierungselement 16a zu einem Großteil von der Ausnehmung 20a aufgenommen. Das Positionierungselement 16a wird mittels des Randkartensteckers 12a aus der Fixierstellung in die Auslenkstellung bewegt. Bei der Herstellung der Kontaktierung des Randkartensteckers 12a mit der Leiterplatte 14a wird das Positionierungselement 16a durch den Randkartenstecker 12a aus der Fixierstellung in die Auslenkstellung bewegt.

Der Randkartenstecker 12a wird in einer im Wesentlichen parallel zu der Haupterstreckungsebene der Gehäuseeinheit 18a ausgerichteten Befestigungsrichtung auf die Leiterplatte 14a zubewegt und mit der Leiterplatte 14a kontaktiert. Nach Beendigung einer Betätigung des Betätigungsabschnitts 22a durch den Randkartenstecker 12a bewegt sich das Positionierungselement 16a selbsttätig aus der Auslenkstellung in die Fixierstellung. In der Fixierstellung des Positionierungselements 16a wird der Randkartenstecker 12a in der Position relativ zu der Leiterplatte 14a mittels des Positionierungselements 16a fixiert.

In Fig. 6 ist ein weiteres Ausführungsbeispiel der Erfindung gezeigt. Die nachfolgenden Beschreibungen beschränken sich im Wesentlichen auf die Unterschiede zwischen den Ausführungsbeispielen, wobei bezüglich gleich bleibender Bauteile, Merkmale und Funktionen auf die Beschreibung des Ausführungsbeispiels der Fig. 1 bis 5 verwiesen werden kann. Zur Unterscheidung der Ausführungsbeispiele ist der Buchstabe a in den Bezugszeichen des Ausführungsbeispiels in den Fig. 1 bis 5 durch den Buchstaben b in den Bezugszeichen des Ausführungsbeispiels der Fig. 6 ersetzt. Bezüglich gleich bezeichneter Bauteile, insbesondere in Bezug auf Bauteile mit gleichen Bezugszeichen, kann grundsätzlich auch auf die Zeichnungen und/oder die Beschreibung des Ausführungsbeispiels der Fig. 1 bis 5 verwiesen werden.

Fig. 6 zeigt eine Kochfeldvorrichtung 10b eines Kochfelds 26b. Die Kochfeldvorrichtung 10b umfasst einen Randkartenstecker 12b, der eine Leiterplatte 14b der Kochfeldvorrichtung 10b kontaktiert. Die Kochfeldvorrichtung 10b umfasst ein Positionierungselement 16b, das von dem Randkartenstecker 12b verschieden ausgebildet ist und den Randkartenstecker 12b in einer Position relativ zu der Leiterplatte 14b fixiert. Das Positionierungselement 16b, welches den Randkartenstecker 12b von einer der Leiterplatte 14b abgewandten Seite her in der Position relativ zu der Leiterplatte 14b fixiert, ist einstückig mit einer Gehäuseeinheit 18b der Kochfeldvorrichtung 10b verbunden. An einem der Leiterplatte 14b abgewandten Ende weist das Positionierungselement 16b einen Haken 38b auf. Das Positionierungselement 16b weist einen Betätigungsabschnitt 22b auf. Der Betätigungsabschnitt 22b ist als ein Teilbereich des Hakens 38b ausgebildet.

### BEZUGSZEICHEN

- 10: Kochfeldvorrichtung
- 12: Randkartenstecker
- 14: Leiterplatte
- 16: Positionierungselement
- 18: Gehäuseeinheit
- 20: Ausnehmung
- 22: Betätigungsabschnitt
- 24: Wand
- 26: Kochfeld
- 28: Kochfeldplatte
- 30: Bedieneinheit
- 32: Steuereinheit
- 34: Halteelement
- 36: Verbindungsabschnitt
- 38: Haken

## Patentansprüche

1. Kochfeldvorrichtung mit zumindest einem Randkartenstecker (12a-b), der dazu vorgesehen ist, eine Leiterplatte (14a-b) zu kontaktieren, **gekennzeichnet durch** zumindest ein Positionierungselement (16a-b), das von dem Randkartenstecker (12a-b) verschieden ausgebildet und dazu vorgesehen ist, den Randkartenstecker (12a-b) in einer Position relativ zu der Leiterplatte (14a-b) zu fixieren, wobei das Positionierungselement (16a-b) dazu vorgesehen ist, den Randkartenstecker (12a-b) und/oder die Leiterplatte (14a-b) zu einer Fixierung einer Position des Randkartensteckers (12a-b) relativ zu der Leiterplatte (14a-b) wenigstens teilweise zu berühren.

2. Kochfeldvorrichtung nach Anspruch 1, **dadurch gekennzeichnet, dass** das Positionierungselement (16a-b) dazu vorgesehen ist, den Randkartenstecker (12a-b) von einer der Leiterplatte (14a-b) abgewandten Seite her in der Position relativ zu der Leiterplatte (14a-b) zu fixieren.

3. Kochfeldvorrichtung nach einem der vorhergehenden Ansprüche, **gekennzeichnet durch** eine Gehäuseeinheit (18a-b), mit welcher das Positionierungselement (16a-b) verbunden ist, wobei die Gehäuseeinheit (18a-b) in wenigstens einen montierten Zustand wenigstens teilweise eine Begrenzung zumindest eines Hohlraums ausbildet, welcher dazu vorgesehen ist, in einem montierten Zustand zumindest eine Einheit und/oder zumindest ein Element aufzunehmen.

4. Kochfeldvorrichtung nach Anspruch 3, **dadurch gekennzeichnet, dass** das Positionierungselement (16a-b) einstückig mit der Gehäuseeinheit (18a-b) verbunden ist.

5. Kochfeldvorrichtung nach Anspruch 3 oder 4, **dadurch gekennzeichnet, dass** das Positionierungselement (16a-b) zumindest teilweise relativ zu zumindest einem Teilbereich der Gehäuseeinheit (18a-b) auslenkbar ist.

6. Kochfeldvorrichtung nach Anspruch 5, **dadurch gekennzeichnet, dass** die Gehäuseeinheit (18a-b) zumindest eine Ausnehmung (20a-b) aufweist, die dazu vorgesehen ist, das Positionierungselement (16a-b) in wenigstens einer Auslenkstellung wenigstens zu einem Großteil aufzunehmen.

7. Kochfeldvorrichtung nach Anspruch 6, **dadurch gekennzeichnet, dass** das Positionierungselement (16a-b) zumindest einen Betätigungsabschnitt (22a-b) zu einer Auslenkung des Positionierungselements (16a-b) aus einer Fixierstellung in die Auslenkstellung aufweist.

8. Kochfeldvorrichtung nach einem der Ansprüche 3 bis 7, **dadurch gekennzeichnet, dass** das Positionierungselement (16a-b) als eine aus einer Wand (24a-b) der Gehäuseeinheit (18a-b) freigestellte Zunge ausgebildet ist.

9. Kochfeld, insbesondere Induktionskochfeld, mit zumindest einer Kochfeldvorrichtung (10a-b) nach einem der vorhergehenden Ansprüche.

10. Verfahren zur Montage einer Kochfeldvorrichtung (10a-b), insbesondere nach einem der Ansprüche 1 bis 8, mit einer Leiterplatte (14a-b) und zumindest einem Randkartenstecker (12a-b), der mit der Leiterplatte (14a-b) kontaktiert wird, **dadurch gekennzeichnet, dass** der Randkartenstecker (12a-b) in einer Position relativ zu der Leiterplatte (14a-b) mittels zumindest eines Positionierungselements (16a-b), das von dem Randkartenstecker (12a-b) verschieden ausgebildet ist, fixiert wird, wobei das Positionierungselement (16ab) den Randkartenstecker (12a-b) und/oder die Leiterplatte (14a-b) zu einer Fixierung einer Position des Randkartensteckers (12a-b) relativ zu der Leiterplatte (14a-b) wenigstens teilweise berührt.

11. Verfahren nach Anspruch 10, **dadurch gekennzeichnet, dass** das Positionierungselement (16a-b) bei einer Kontaktierung des Randkartensteckers (12a-b) mit der Leiterplatte (14a-b) durch den Randkartenstecker aus einer Fixierstellung in eine Auslenkstellung überführt wird.

## Claims

1. Cooking hob device having at least one boundary board connector (12a-b), which is provided to contact a circuit board (14a-b), **characterised by** at least one positioning element (16a-b) which is embodied to differ from the boundary board connector (12a-b) and is provided to fix the boundary board connector (12a-b) in a position relative to the circuit board (14a-b), wherein the positioning element (16a-b) is provided to touch the boundary board connector (12a-b) and/or the circuit board (14a-b), to some extent at least, for the purpose of fixing a position of the boundary board connector (12a-b) relative to the circuit board (14a-b).

2. Cooking hob device according to claim 1, **characterised in that** the positioning element (16a-b) is provided to fix the boundary board connector (12a-b) from a side facing away from the circuit board (14a-b) in the position relative to the circuit board (14a-b).

3. Cooking hob device according to one of the preceding claims, **characterised by** a housing unit (18a-b), with which the positioning element (16a-b) is connected, wherein in at least one assembled state the housing unit (18a-b) embodies a border of at least one cavity, at least to some extent, which is provided to receive at least one unit and/or at least one element in an assembled state.

4. Cooking hob device according to claim 3, **characterised in that** the positioning element (16a-b) is connected in one piece with the housing unit (18a-b).

5. Cooking hob device according to claim 3 or 4, **characterised in that** the positioning element (16a-b) can be deflected at least partially relative to at least one subregion of the housing unit (18a-b).

6. Cooking hob device according to claim 5, **characterised in that** the housing unit (18a-b) has at least one cutout (20a-b), which is provided to receive at least a large part of the positioning element (16a-b) in at least one deflection position.

7. Cooking hob device according to claim 6, **characterised in that** the positioning element (16a-b) has at least one actuation section (22a-b) for deflecting the positioning element (16a-b) from a fixing position into the deflection position.

8. Cooking hob device according to one of claims 3 to 7, **characterised in that** the positioning element (16a-b) is embodied as a tab released from a wall (24a-b) of the housing unit (18a-b).

9. Cooking hob, in particular induction cooking hob, having at least one cooking hob device (10a-b) according to one of the preceding claims.

10. Method for assembling a cooking hob device (10a-b), in particular according to one of claims 1 to 8, having a conductor board (14a-b) and at least one boundary board connector (12a-b), which is in contact with the conductor board (14a-b), **characterised in that** the boundary board connector (12a-b) is fixed in a position relative to the conductor board (14a-b) by means of at least one positioning element (16a-b), which is embodied to differ from the boundary board connector (12a-b), wherein the positioning element (16a-b) is provided to touch the boundary board connector (12a-b) and/or the circuit board (14a-b), to some extent at least, for the purpose of fixing a position of the boundary board connector (12a-b) relative to the circuit board (14a-b).

11. Method according to claim 10, **characterised in that** upon contact between the boundary board connector (12a-b) and the conductor board (14a-b) the positioning element (16a-b) is moved from a fixing position into a deflection position by the boundary board connector.

## Revendications

1. Dispositif de champ de cuisson avec au moins un connecteur de carte périphérique (12a-b), prévu afin de contacter un circuit imprimé (14a-b), **caractérisé par** au moins un élément de positionnement (16a-b), exécuté différemment par le connecteur de carte périphérique (12a-b) et prévu afin de fixer le connecteur de carte périphérique (12a-b) dans une position par rapport au circuit imprimé (14a-b), dans lequel l'élément de positionnement (16a-b) est prévu afin de toucher au moins partiellement le connecteur de carte périphérique (12a-b) et/ou le circuit imprimé (14a-b) pour une fixation d'une position du connecteur de carte périphérique (12a-b) par rapport au circuit imprimé (14a-b).

2. Dispositif de champ de cuisson selon la revendication 1, **caractérisé en ce que** l'élément de positionnement (16a-b) est prévu afin de fixer le connecteur de carte périphérique (12a-b) au départ d'un côté éloigné du circuit imprimé (14a-b) dans la position par rapport au circuit imprimé (14a-b).

3. Dispositif de champ de cuisson selon l'une des revendications précédentes, **caractérisé par** une unité de carcasse (18a-b) à laquelle l'élément de positionnement (16a-b) est relié, dans lequel l'unité de carcasse (18a-b) constitue dans au moins un état monté au moins en partie une délimitation d'au moins une cavité, prévue afin d'accueillir dans un état monté au moins une unité et/ou au moins un élément.

4. Dispositif de champ de cuisson selon la revendication 3, **caractérisé en ce que** l'élément de positionnement (16a-b) est relié en une seule pièce à l'unité de carcasse (18a-b).

5. Dispositif de champ de cuisson selon la revendication 3 ou 4, **caractérisé en ce que** l'élément de positionnement (16a-b) est déplaçable au moins partiellement par rapport à l'au moins une zone partielle de l'unité de carcasse (18a-b).

6. Dispositif de champ de cuisson selon la revendication 5, **caractérisé en ce que** l'unité de carcasse (18a-b) présente au moins un évidement (20a-b) prévu afin d'accueillir au moins en grande partie l'élément de positionnement (16a-b) dans au moins une position déplacée.

7. Dispositif de champ de cuisson selon la revendication 6, **caractérisé en ce que** l'élément de positionnement (16a-b) présente au moins une section d'actionnement (22a-b) pour un déplacement de l'élément de positionnement (16a-b) au départ de la position fixe vers la position déplacée.

8. Dispositif de champ de cuisson selon l'une des revendications 3 à 7, **caractérisé en ce que** l'élément de positionnement (16a-b) est exécuté sous la forme d'une langue libérée d'une paroi (24a-b) de l'unité de carcasse (18a-b).

9. Champ de cuisson, en particulier champ de cuisson à induction, avec au moins un dispositif de champ de cuisson (10a-b) selon l'une des revendications précédentes.

10. Procédé pour le montage d'un dispositif de champ de cuisson (10a-b), en particulier selon l'une des revendications 1 à 8, avec un circuit imprimé (14a-b) et au moins un connecteur de carte périphérique (12a-b) porté en contact avec le circuit imprimé (14a-b), **caractérisé en ce que** le connecteur de carte périphérique (12a-b) est fixé dans une position par rapport au circuit imprimé (14a-b) à l'aide d'au moins un élément de positionnement (16a-b) exécuté différemment par le connecteur de carte périphérique (12a-b), dans lequel l'élément de positionnement (16a-b) touche au moins partiellement le connecteur de carte périphérique (12a-b) et/ou le circuit imprimé (14a-b) pour une fixation d'une position du connecteur de carte périphérique (12a-b) par rapport au circuit imprimé (14a-b).

11. Procédé selon la revendication 10, **caractérisé en ce que** l'élément de positionnement (16a-b) est transféré, lors d'un contact du connecteur de carte périphérique (12a-b) avec le circuit imprimé, (14a-b) par le connecteur de carte périphérique d'une position de fixation vers une position déplacée.
